# EUROPEAN PATENT SPECIFICATION

(11) **EP 3 889 622 B1**
(45) Date of publication and mention of the grant of the patent: **27.03.2024**
(21) Application number: 20168059.2
(22) Date of filing: 03.04.2020
(51) Int. Cl.: G01R 27/28, G01R 31/11, G01R 31/58, H04B 3/462

(54) **DELAY MEASUREMENT OF A CABLE**
VERZÖGERUNGSMESSUNG EINES KABELS
MESURE DE RETARD D'UN CÂBLE

(43) Date of publication of application: 06.10.2021
(73) Proprietor: Nokia Solutions and Networks Oy, 02610 Espoo (FI)
(72) Inventor: KOCH, Werner, 71282 HEMMINGEN (DE); LOEHR, Juergen, 70190 STUTTGART (DE)
(74) Representative: Novagraaf Technologies

(56) References cited:
- EP-A2- 0 292 686
- WO-A1-01/88726
- WO-A1-2019/164476
- DE-A1- 10 131 309
- US-A1- 2006 290 356
- US-A1- 2007 250 741
- US-A1- 2013 106 399
- US-A1- 2018 306 849

## Description

### Technical Field

Various example embodiments relate generally to methods and apparatus for delay measurement. In particular, they relate to methods and apparatus for delay measurement of cables.

### Background

Mobile Fronthaul Transport for 5G networks requires ultra-precise timing to supply the Radio Unit (RU) with precise frequency, phase and time information. For this, PTP (Precision Time Protocol) is employed as one of the protocols to transport timing information from the Centralized Unit (CU) or Distributed Unit (DU) to the RU.

IEEE P802.1CM, which is a standard relating to "Time-sensitive networking for fronthaul", defines architectures and timing requirements to be fulfilled by the Mobile Fronthaul equipment, being used for example in an Optical Networking (ON).

In order to support the PTP (Precise Timing Protocol) timing precision as defined in IEEE P802.1 CM standard, the length of cables used inside network elements (NE) need to be known at a high precision, in order to determine the propagation delay with a sufficient precision, e.g. a nanosecond-level precision. For instance, an error of 5 nanoseconds is equivalent to a distance variation of roughly 1 meter.

Document US2018306849A1 discloses a method for Passive Signal Propagation Delay Calculations.

### Summary

According to a first aspect, disclosed is an apparatus for measuring propagation delay in a cable, the apparatus being configured to send through a first conductive line of the cable an enable signal to a remote apparatus, the enable signal being indicative of a start of a measurement period; send, during the measurement period, a synchronization signal to the remote apparatus through a second conductive line of the cable, the synchronization signal including an initial signal edge; detect a reflected signal edge in the synchronization signal, wherein the reflected signal edge is generated by reflection of the initial signal edge at the remote apparatus; determine a propagation delay for the cable, wherein said propagation delay is half of a time difference between the sending of the initial signal edge by the apparatus and the reception of the reflected signal edge by the apparatus. In some examples, the initial signal edge is a falling edge and the reflected signal edge is a rising edge or vice versa. In some examples, the apparatus is configured to apply to a first end of the second conductive line a change of voltage to generate the initial signal edge and to detect a negated change of voltage corresponding to the reflected signal edge. In some examples, the synchronization signal comprises a periodic variation between a low logic level and a high logic level, the periodic variation defining signal edges, the apparatus is configured to send the enable signal after a first signal edge of the synchronization signal and before the next signal edge within a same synchronization period, the next signal edge is the initial signal edge. In some examples, the apparatus is configured to send a disable signal to the remote apparatus through the first conductive line after the detection of the reflected signal edge, the disable signal being indicative of an end of the measurement period. In some examples, the apparatus is configured to send through the first conductive line data frames according to a protocol, the apparatus is configured to include the enable signal in a data frame according to said protocol.

According to a second aspect, disclosed is an apparatus configured to : receive, through a first conductive line of the cable, an enable signal from a remote apparatus; after receipt of the enable signal, initiating a measurement period in which the apparatus is configured to change an electrical configuration for causing a reflection of a synchronization signal received by the apparatus at an end of a second conductive line connected to the apparatus; receive a synchronization signal from the remote apparatus at said end of the second conductive line; reflect said received synchronization signal to the remote apparatus using said second conductive line. In some examples, the change in the electrical configuration includes changing the electrical connection of the end of the second conductive line. In some examples, changing the electrical connection of the end of the second conductive line includes forcing a short circuit or an open circuit to cause the reflection at the end of the second conductive line. In some examples, the apparatus is configured to receive through the first conductive line a disable signal from the remote apparatus and to interrupt the reflection at the end of a second conductive line after receipt of the disable signal. In some examples, the apparatus is configured to start a timeout period after receipt of the enable signal and to interrupt the reflection at the end of a second conductive line after the timeout period has lapsed.

According to a third aspect, disclosed is a network element comprising an apparatus according to the first aspect or an apparatus according to the second aspect.

According to a fourth aspect, disclosed is a method for propagation delay determination, the method comprising sending, from a first apparatus, through a first conductive line of a cable an enable signal to a second apparatus to indicate a start of a measurement period; sending, during the measurement period, a synchronization signal from the first apparatus to the second apparatus through a second conductive line of the cable, the synchronization signal including an initial signal edge; detecting, by the first apparatus, a reflected signal edge in the synchronization signal, the reflected signal edge being generated by reflection of the initial signal edge at the second apparatus; determining a propagation delay for the cable, the propagation delay being half of a time difference between the sending of the initial signal edge by the apparatus and the reception of the reflected signal edge by the apparatus.

According to a fifth aspect, disclosed is a method for configuring an apparatus for measuring propagation delay, the method comprising : receiving, through a first conductive line of a cable, an enable signal from a remote apparatus; after receipt of the enable signal, initiating a measurement period in which the apparatus is configured to change an electrical configuration for causing a reflection of a synchronization signal received by the apparatus at an end of a second conductive line connected to the apparatus; receiving a synchronization signal from the remote apparatus at said end of the second conductive line; reflecting the received synchronization signal to the remote apparatus using the second conductive line.

According to another aspect, disclosed is an apparatus comprising at least one processor; at least one memory including computer program code; the at least one memory and the computer program code being configured to, with the at least one processor, cause the apparatus at least to perform the method according to the fourth aspect. In some examples, the at least one memory and the computer program code being configured to, with the at least one processor, cause the apparatus at least to perform: sending, through a first conductive line of a cable an enable signal to a remote apparatus to indicate a start of a measurement period; sending, during the measurement period, a synchronization signal to the remote apparatus through a second conductive line of the cable, the synchronization signal including an initial signal edge; detecting, a reflected signal edge in the synchronization signal, wherein the reflected signal edge is generated by reflection of the initial signal edge at the remote apparatus; determining a propagation delay for the cable, wherein said propagation delay is half of a time difference between the sending of the initial signal edge by the apparatus and the reception of the reflected signal edge by the apparatus.

### Brief Description of the Drawings

Example embodiments will now be described with reference to the accompanying drawings, in which:
FIG. 1 illustrate principles of delay measurement for a cable connected between two terminal elements according to the present disclosure;
FIG. 2 shows a cable connected between two terminal elements according to an exemplary application of the present disclosure;
FIG. 3 shows network elements according to a further exemplary application of the present disclosure;
FIG. 4 illustrates timing diagrams involved in the delay measurement according to the present disclosure;
FIG. 5 is a flow chart showing a method for delay measurement performed at a terminal element according to the present disclosure;
FIG. 6 is a flow chart showing the method for configuring a terminal element according to the present disclosure; and
FIG. 7A shows an example electronic circuitry with Low Voltage Differential Signaling (LVDS) for realizing delay measurement according to the present disclosure;
FIG. 7B shows the relationship between time and various voltage levels at different point of the circuitry.

### Detailed Description

Example embodiments will now be described, including apparatus and method for delay measurement of a cable.

As the cable length inevitably creates propagation delays in signal propagation, in order to provide the required timing precision, it is required to know the internal delays in a network element implementing for example PTP.

In systems that are built within one shelf, these delays can be known by design, e.g. delays within Application-Specific Integrated Circuit (ASIC)s, Field-Programmable Gate Array (FPGA)s, and on traces on Printed Component Board (PCB)s and backplanes, and can be considered accordingly by the PTP implementation.

However, in systems that span several shelves, cables (electrical or optical) are used to connect the different shelves that constitute one network element. These cables may have different length depending on the customer specific configuration, and the lengths may change over time e.g. as the result of repair actions that involve exchange of cables.

The cable lengths are typically configured into the system to be taken into account by the PTP implementation, but this information is potentially imprecise due to various factors such as database errors, human mistake on data entry, human mistake during cabling of the system, cable replacement with length change being not reflected by an update of the length information.

Such impreciseness will decrease the precision of timing implemented by PTP, and may lead to non-standard compliant system configuration, with impaired behavior and/or performance of the supported Mobile Network.

Thus, it is desirable to provide a network element and a method for implementing a delay measurement that can provide higher precision in the internal cable delays inside the network element, and which measurement method can to be automated and be repeated.

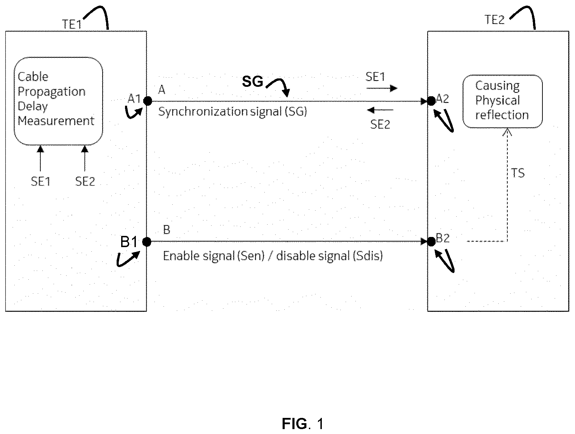

FIG. 1 illustrates the principle of delay measurement for a cable connected between two terminal elements according to the present disclosure.

With reference to FIG. 1, a system is shown including a first terminal element TE1 and second terminal element TE2 connected by a cable between first terminal element TE1 and second terminal element TE2. A terminal element may designate any physical unit or device or apparatus configured to be connected to one end or one terminal of a cable.

A first apparatus for measuring a propagation delay may comprise or may correspond to the first terminal element TE1, and a second apparatus for measuring a propagation delay may comprise or correspond to the second terminal element TE2. The second apparatus is a remote apparatus from the point of view of the first apparatus and vice versa. An apparatus for measuring propagation delay in a cable may be any apparatus comprising means for or being configured to measure propagation delay in a cable or may be an apparatus comprising means for or being configured to perform step(s) used for measuring propagation delay in a cable as described herein. Each of the first and second terminal element or apparatus TE1, TE2 may be included in a network element or network node.

As shown in FIG. 1, the cable connected between first terminal element TE1 and second terminal element TE2 comprises at least two conductive lines, referred to as the first conductive line B and the second conductive line A. The conductive lines inside a cable have all substantially the same length. According to one example, the conductive line may comprise a differential pair of conductors. According to another example, the conductive line may be a single electrical wire. In some examples, the wires are contained in a CAT7 cable with 8P8C modular connectors, also referred to as RJ45 connectors

As shown in FIG. 1, the second conductive line A comprises a first end A1 and a second end A2. According to some embodiments, first end A1 is configured to be connected to first terminal element TE1 and second end A2 is configured to be connected to second terminal element TE2. Similarly a first end B 1 of conductive line B is connected to the first terminal element TE1 and a second end B2 of the conductive line B is connected to the second terminal element TE2.

One or more signals may be transmitted through the second conductive line A.

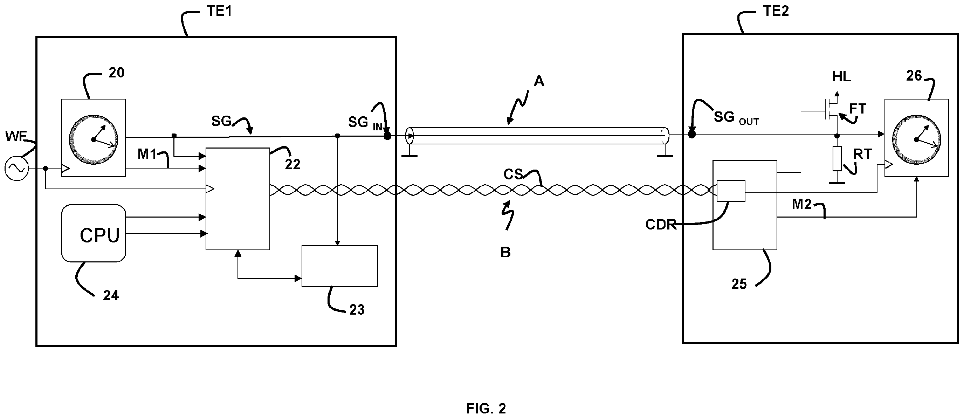

As shown in FIG. 1, a signal SG is sent in the direction from first terminal element TE1 to second terminal element TE2 (shown as left to right), and more specifically from first end A1 to second end A2. To maintain simplicity, the first terminal element TE1 is also referred to herein simply as TE1 and the second terminal element TE2 is also referred to herein as TE2. According to an example of the present disclosure, the signal SG is used in a process to determine propagation delay in the cable. According to some embodiments, the signal SG may be a synchronization signal or clock signal which is transmitted for synchronization between the first terminal element TE1 and the second terminal element TE2, as described in further detail with reference to FIG. 2.

It is to be noted that according to the present disclosure, the communication through the conductive line A is unidirectional, that is, the first terminal element TE1 is configured to send the signal SGto the second terminal element TE2 but the second terminal element TE2 does not send any signal, for the purpose of the intended delay measurement, to the first terminal element TE1 through the conductive line A.

Bi-directional communication is often used for loop-back measurement. In such case, symmetry of propagation delay in the two directions is ensured by the bidirectional paths. In other words, the delay values in the two directions namely from TE1 to TE2 and from TE2 to TE1, will be the same, so only the total round trip delay is needed which equals twice the path delay to be measured.

Contrary to the traditional bi-directional communication, the conductive line A used by the present disclosure for transmitting the signal SG is unidirectional. Drawbacks of adopting unidirectional communication is that possible asymmetries may become relevant, and thus delay measurement based on calculating round-trip delay may be no longer applicable.

The present disclosure is aimed at measuring propagation delay by using a simple method with the minimum electronics based on the use of signal edges and reflection induced at second end A2 of the conductive line A on a initial signal edge, as will be explained herein in more details.

On the direction from TE1 to TE2, and more specifically from the first end A1 to the second end A2, a synchronization signal SG is transmitted from the first end A1 to the second end A2 through the second conductive line A including a initial signal edge SE1 .

The synchronization signal SG may vary periodically between a low logic level and a high logic level and the signal edges may have a relative sharp form. In some embodiments, the synchronization signal SG has a substantially square wave form. In some embodiments, the synchronization signal SG has other forms where the wave ramps upwards and downwards linearly. Depending on two types of signal edges, the synchronization signal SG may have a rising edge (from logic low to logic high), and a falling edge (from logic high to logic low). Only one type of signal edge (rising or falling) is used for the original synchronization purpose. Another type of signal edge (falling or rising) is used for propagation delay measurement. In some examples, rising edge of signal SG is used for synchronization purpose. In some other examples, falling edge of signal SG is used for synchronization purpose.

The first signal edge SE1 may be a falling edge or a rising edge. The first signal edge SE1 may be inserted in the signal SG specifically for the purpose of the propagation delay measurement. Alternatively, an existing signal edge in the synchronization signal SG may be used as first signal edge for the propagation delay measurement.

According to some embodiments, the signal edge SE1 may be generated by applying by TE1 a change of voltage applied to the first end A1 of the conductive line A.

Still through the second conductive line A but in a reversed direction, namely from TE2 to TE1, and more specifically from the second end A2 to first end A1, a reflected signal edge SE2 is generated at the second end A2 of the second conductive line A. The reflected signal edge SE2 is propagated back through the second conductive line A such that this reflected signal edge SE2 is detectable at the first end A1 by the first terminal element. The reflected signal edge SE2 may be caused by a short circuit at the second end A2, such that the reflected signal edge SE2 is a negated signal edge compared to the initial signal edge SE1: when the initial signal edge SE1 is a falling edge, the reflected signal edge SE2 is a rising edge and vice versa. The reflected signal edge SE2 may also be caused by an open circuit at the second end A2 such that other type of reflection with another signal shape is generated.

The reflection corresponds to an electrical phenomenon (i.e. physical reflection) achieved by a specific electrical configuration (electrical connection) of the second end of the second conductive line A in the second terminal element TE2. Hence the second terminal element TE2 does not need to send any signal through the second conductive line A. Here the right-to-left arrow in FIG. 1 above "SE2" may indicate the direction that SE2 signal travels (from TE2 to TE1), but this arrow does not mean that the second terminal element TE2 is configured to sends any signal to the first terminal element TE1.

The reflection may be obtained in various ways. For example by pulling and maintaining the second end A2 of the second conductive line A to a predetermined voltage level. The predetermine level may correspond to the high logic level of the synchronization signal. The second terminal element may also force a short circuit or an open circuit to cause the reflection.

As this reflection phenomenon is undesirable for the use of the synchronization signal in normal operating mode, a measurement mode may be implemented for this purpose when this reflection has to be activated. To activate the measurement, one or more control signals are transmitted through a first conductive line B of the same cable.

According to some examples, additional signals may be transmitted through first conductive line B, for example control signals. The signals may be used to send data frames according to a given control protocol, for example the PTP (Precision Timing Protocol). In some examples, a control signal is used for indicating the enablement of the measurement mode to initiate the measurement mode. In some examples, a control signal is used for indicating the delay measurement end. A slave clock on the TE2 may then be informed to do an alignment with respect to a master clock on TE1.

According to some examples, the first terminal element TE1 sends an enable signal (Sen) to second terminal element TE2 through the first conductive line B. The enable signal (Sen) may be transmitted in a data frame according to any control protocol. The enable signal Sen is used to inform the second terminal element TE2 of the start of the measurement period and to cause the second terminal element TE2 to enter into the measurement mode in which the second terminal element TE2 is configured to cause reflection at the second end A2 of the second conductive line A after receipt (e.g. upon receipt) of the enable signal.

According to some examples, after the reflected signal edge SE2 is detected by the first terminal element TE1 or after the propagation delay is determined by the first terminal element TE1, the first terminal element TE1 sends a disable signal Sdis to the second terminal element TE2 to indicate the end of measurement period. The disable signal (Sdis) may be transmitted in a data frame according to any control protocol. The disable signal (Sdis) is for causing the second terminal element TE2 to exit from the measurement mode after the detection of the reflected signal edge SE2, i.e., to interrupt the reflection at the end of a second conductive line A. Interrupting the reflection may include deactivating the specific electrical configuration that causes signal reflection at the second end A2 of the second conductive line A.

According to some examples, the second terminal element TE2 is configured to start a timeout period upon receipt of the enable signal Sen and to interrupt the reflection at the end of a second conductive line A after the timeout period has lapsed without using any disable signal.

In addition to the functions of the first terminal element TE1 described in relation to signal transmissions through the conductive lines A and B, the first terminal element TE1 is configured to detect the reflected signal edge SE2 and to determine a propagation delay for the cable on the basis of half of a time difference between the initial signal edge SE1 and reflected signal edge SE2.

As explained by reference to FIG. 1, the delay measurement may be implemented by transmitting a synchronization signal SG on second conductive line A, the synchronization signal SG including a signal edge SE1 inserted at first end A1. This signal edge is reflected or fed back upon reception by second end A2 towards first end A1. The round-trip delay is determined from the difference of time between sending the signal edge SE1, and receiving the reflected signal edge SE2 of SE1. The cable delay to be calculated equals half of the measured round-trip time as if the two-way transmission in the cable were symmetric without employing bi-directional wire for transmitting the signal SG.

According to some examples, the synchronization signal may comprise a periodic variation between a low logic level and a high logic level, this periodic variation defining signal edges, e.g. at least two signal edges in a synchronization period. The apparatus may be configured to send the enable signal Sen after a first signal edge of the synchronization signal and before the next signal edge within a same synchronization period, wherein the next signal edge is used as the initial signal edge SE1 for which the reflected signal edge SE2 is detected.

The implementation according to the present disclosure thus allows to achieve a precision better than several nanoseconds of round-trip delay, corresponding to several centimeters in cable length, or even better precisions. It is to be noticed that the synchronization period of the periodic variation of the synchronization signal is such that a round-trip delay can occur within half of this synchronization period.

One further advantage of the proposed solution is the low-cost involved with the use of extra electronics required both for configuring the second terminal element for the reflection and for configuring the first terminal element for delay measurement between the two signal edges SE1 and SE2 at the first terminal element and sending of the enable / disable signals.

FIG. 2 shows terminal elements according to an exemplary application of the present disclosure.

According to FIG. 2, the signal SG is a synchronization signal. In some examples, the synchronization signal SG is used to align a slave clock circuitry 26 in the second terminal element TE2 to a master clock circuitry 20 in the first terminal element TE1. In some examples, the master clock circuitry 20 generates the synchronization signal SG.

In order that both clock circuitries 20 and 26 run with the same working frequency WF, the synchronization signal SG is generated at first terminal element TE1 by Master clock 20 and the working frequency WF is sent embedded in a control signal CS to second terminal element TE2. The Master clock 20 may generate an associated message M1 e.g. "At the SG it was 8 p.m,". The message M1 may include a timestamp. The synchronization signal SG may have a frequency for example equal to 16Hz. More generally the synchronization period of the periodic variation of the synchronization signal is such that a round-trip delay can occur within half of this synchronization period.

In some examples, the Precision Time Protocol, PTP, defined by IEEE 1588-2008 works by exchanging messages M1 and M2 between master clock and slave clock to synchronize clocks. The synchronization signal SG is sent with a known delay from master clock 20 (on TE1) to slave clock 26 (on TE2). After completion the delay measurement, the control logic 22 can modify the timestamp (e.g. 8 p.m.) in the message M1. The modified message M2 is embedded in the control signal CS. When the slave clock 26 receives cable-delayed synchronization signal SG (referred to as SG_{OUT}) and the modified message M2 on TE2, the slave clock 26 can be set synchronal to the master clock.

It is proposed in the present disclosure to divert the synchronization signal SG, from its above intended use for synchronization occasionally, without causing negative effects on the accuracy of the receiving end (second end A2) if it is done at a time.

To this end and with reference to FIG. 2, the synchronization signal SG and the control signal CS are transmitted separately through two distinct conductive lines (i.e. conductive lines A and B in FIG. 1). According to some embodiments, the synchronization signal SG is transmitted through the second conductive line A. Still according to some embodiments, the control signal CS is transmitted through a first conductive line B. According to some examples, the enable signal Sen and/or the disable signal Sdis are each embedded in a data frame of the control signal CS.

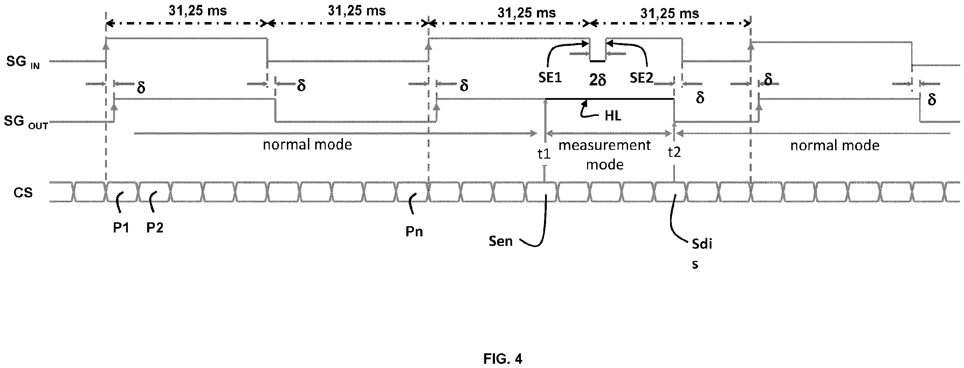

According to some examples, the synchronization signal SG is transmitted through the second conductive line A from TE1 to TE2. The first terminal element TE1 may comprise a processing unit, e.g. CPU 24, which triggers the sending by the control logic 22 of the enable signal Sen and / or the disable signal Sdis by sending a trigger signal or command to the control logic 22. The CPU 24 may also send other information to the control logic 22 for TE1. The control logic 22 which receives the synchronization signal SG, waits until the master clock has generated the rising edge (i.e. initial signal edge to be used for measurement) of the synchronization signal SG and then the control logic 22 sends the enable signal Sen. through the first conductive line B from TE1 to TE2 as illustrated by FIG. 4. The enable signal Sen is embedded in a data frame of the control signal CS.

The synchronization signal SG detected at the first end A1 is referred to as "SG_{IN}" and may include the initial signal edge SE1 and the reflected signal edge SE2.

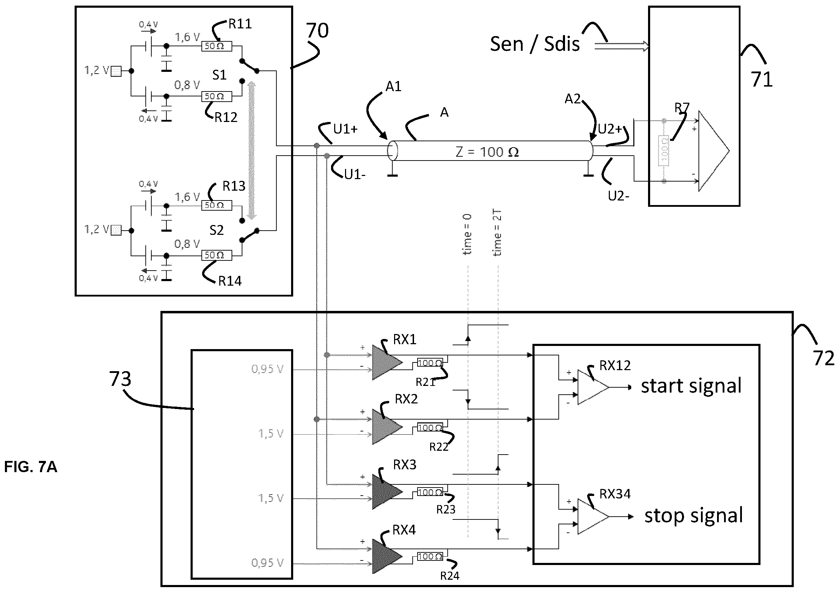

The first terminal element TE1 may further comprise a measurement circuitry 23 (e. g. accurate pulse length measurement") for measuring propagation delay by determining a time difference based on the initial signal edge SE1 and the reflected signal edge SE2. The propagation delay obtained by the measurement circuitry 23 is then fed back to the control logic 22. Examples of a circuitry for performing pulse length measurements will be described in more details with reference to FIG. 7A.

According to some examples, the slave clock 26 at the second terminal element TE2 receives SG_{OUT} (i.e. the synchronization signal SG detected at the second end A2 of the conductive line A). The slave clock 26 also receives the modified message M2 from the control logic 25 of the second terminal element TE2, as well as the working frequency of the slave clock 26 from a Clock Data Recovery (CDR) circuit being comprised in the control logic 25 for TE2. Consequently the master clock and the slave clock have the identical working frequency. The second terminal element TE2 may further comprise electronic components being configured to induce reflected signal at the second end A2 of the second conductive line A. In the example of FIG. 2, the electronic components that induce reflection at the second end A2 of the conductive line A include a FET (Field effect transistor) transistor FT which upon activation by the control logic 25 operates as a short circuit to pull the level of the conductive line A to a high level HL.

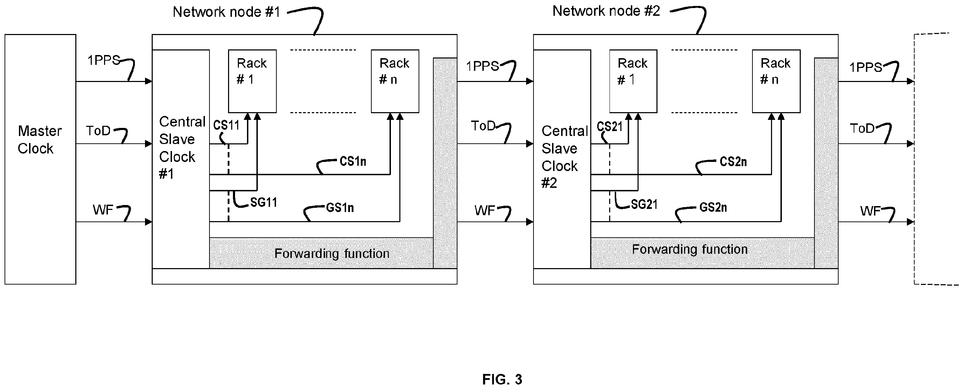

FIG. 3 shows network elements according to a further exemplary application of the present disclosure.

The above descriptions of the master clock and the slave clock is not only applicable for time and phase synchronization between network nodes but is also applicable to the synchronization of several racks within a network node. In this last scenario, as shown in FIG. 3 but only the master clock and network node 1 and the connections between the two components are considered for this example. Network node 1 may comprises n racks Rack 1, Rack 2, ... Rack n. As explained above, the synchronization signal SG and the control signal CS are transmitted from the master clock to the slave clock comprised within the network node 1. The slave clock is herein referred to as "central slave clock 1", where "1" denotes the central slave clock comprised in the network node number 1, which is further connected to the n racks. In some examples, there are a set of synchronization signal and control signal (SG11, CS11) transmitted from the central slave clock to rack 1, a further set of said signals (SG12, CS12) transmitted to rack 2, and so on, up to a set of synchronization signal and control signal (SG1n, CS1n) transmitted to rack n, wherein for example in SG11, SG denotes synchronization signal, the first digit "1" denotes network node 1 or central slave clock 1, the second digit "1" denotes rack number 1. Similarly, there are a set of synchronization signal and control signal (SG21, CS21) transmitted from the Central slave clock 2 to rack 1, a set of (SG21, CS22) transmitted to rack 2, a set of (SG2n, CS2n) transmitted to rack n, wherein for example in SG11, SG denotes synchronization signal, the first digit "2" denotes network node 2, the second digit "1" denotes rack number 1.

With reference to FIG. 3, the solution disclosed herein may be used in the context where several racks between two network nodes are synchronized, for example shown as network node 1 and network node 2 in FIG. 3.

In such context, bidirectional communication and round-trip delay measurement is applied, such as recommended by the ITU standard ITU-T G.8271/Y.1366 (08/2017) defining 1PPS/ToD interface. 1PPS refers to one pulse-per-second, and ToD refers to time of day. The 1PPS time/phase interface uses a point-to-point ITU-T. V.11 interface with an additional requirement on the rise/fall times of the 1PPS signal. This is needed to provide the accuracy required for the 1PPS signal.

In Annex A of this standard, A.1.2 Automatic cable delay compensation describes that the 1PPS ITU-T V.11 interface can optionally support automatic cable delay compensation. The enhanced 1PPS ITU-T V.11 interface adds support for automatic cable and ITU-T V.11 transceiver compensation using a feedback loop that allows the time master to measure the round-trip delay of the 1PPS signal and compensate for the path delay when generating the 1PPS signal.

The 1PPS signal is initially generated by the master clock at the 1-second boundary, T1. This signal is delayed through the cable before it arrives at the central slave clock. The 1PPS signal is looped back at the central slave clock and sent to the master clock. The master clock captures the time of reception of the 1PPS signal from the central slave clock, T2, and measures the round-trip delay as the time since the generation of the 1PPS signal.

Assuming that the path is symmetrical, the master clock calculates the mean cable delay as: (T2 - T1)/2 and either compensates for the cable delays by advancing the 1PPS signal by the mean cable delay or alternatively informs the central slave clock about the mean cable delay through the ITU-T V.11 serial communication channel so that the slave can perform the compensation.

The 1PPS/ToD interface according to the ITU-T G.8271/Y.1366 standard requires symmetry which can be found in bidirectional communication and round-trip delay measurement. Although the present solution involves unidirectional transmission of SG signal rather than bidirectional communication, it provides the same advantage of symmetry as found in the bidirectional or loop-back communication. According to some examples, applying the solution proposed herein may help to simplify the above context of applying round-trip delay measurement.

In other words, the standardized 1PPS/ToD interface which is used for time and phase synchronization between network nodes may be simplified to implement the method and apparatus to measure propagation delay as disclosed herein.

This way, the solution disclosed herein can also be used for ensuring required precision of synchronization between network nodes. In this case, the synchronization signal SG of 16Hz is replaced by 1 PPS of 1Hz, both of which are pulse-shaped signals. In addition, the control signal CS is replaced by ToD signal. The signals transmitted to the central slave clock 1 of the network node 1 is forwarded to the central slave clock 2 of the network node 2 by forwarding function, and so on. Besides these changes, the principles of the proposed solution in this application remain the same as those described above with reference to FIGS. 1 and 2.

FIG. 4 illustrates timing diagrams of the signal waveforms at first terminal element and second terminal element of the cable according to the present disclosure.

With reference to the example shown in FIG. 4, the synchronization signal SG has an example frequency 16Hz, with a synchronization period of the synchronization signal SG being 62.5ms. The frequency of synchronization signal SG is chosen according to two accumulative conditions. In the first condition, the maximum cable-delay must be smaller than half the synchronization period of the synchronization signal SG. In the second condition, the length of the data frames of the control signal CS is considered. Where the signals Sen and Sdis are considered, they should be sent and evaluated within the synchronization period of half of 62.5 ms, i.e. 31.25 ms. In some examples, synchronization signal SG varies periodically between a low logic level and a high logic level. In some examples, synchronization signal has a relatively sharp form such as square form.

In some examples, the working frequency WF may also be embedded into the control signal.. The master clock 20 in TE1 and the slave clock 26 in TE2 must have the same working frequency. In some examples, the control signal CS is used to transport working frequency WF from TE1 to TE2. For example, the control logic 22 receives the working frequency WF and the CDR circuit in the control logic 25 can recover the working frequency WF to be fed to the slave clock 26.

For purpose of understanding, the signal SG at first end A1 will be denoted SG_{IN}, such as the addition of signals SG and control signal, and the signal at second end A2 will be denoted SG_{OUT}.

According to the example as shown in FIG. 4, only the rising edge of the signal SG_{IN} may be employed. In other examples although not shown in the drawings, the falling edge of the signal SG_{IN} may be used.

According to the examples as shown in FIG. 4, the falling edge of SG_{IN} is used for delay measurement. In other examples although not shown in the drawings, rising edge of SG_{IN} may be used for delay measurement.

Furthermore, the frequency of synchronization signal SG (16Hz) is relatively slow. As shown in FIG. 4, the synchronization period between two rising edges of the synchronization signal SG is 62.5ms. The cable propagation delay (δ) is shown between a rising (respectively falling) edge of SG_{IN} and a corresponding rising (respectively falling) edge of SG_{OUT}. The delay of the control signal CS (in which data frame are used to carry packets P1, P2....Pn) is negligible. In other words, the time needed for enabling the measurement mode is not relevant for the accuracy.

The FIG. 4 also illustrate further synchronization aspects between the enable signal Sen and the signal edges SE1 and SE2. When the enable signal Sen is embedded in a data frame of the control signal CS at time t1 the measurement period (i.e. measurement mode) starts. From time t1 the voltage level HL (high logical level in this example) of the synchronization signal SG_{OUT} at the second end A2 of the conductive line A is maintained to a fixed level (e.g. high level HL), thereby causing reflection at the second end A2 of the conductive line A. During the measurement period, the first signal edge SE1 is reflected through the conductive line A and a reflected signal edge SE2 is detected at the first end A1 of the conductive line A, i.e. in the synchronization signal SG_{IN}. The time difference between the first signal edge SE1 and the reflected signal edge SE2 is twice the cable delay δ. At time t2, at the end of the measurement period, e.g. after the detection of the reflected signal edge SE2, the disable signal Sdis is embedded in a data frame of the control signal CS to interrupt the reflection at the second end A2 of the conductive line A. Alternatively a timeout may be triggered upon receipt of the enable signal Sen and the reflection at the second end A2 of the conductive line A be automatically interrupted by the second terminal element TE2 after expiration of the timeout, without using any disable signal. The time difference between the signal edges SE1 and SE2 may be measured to obtain the propagation delay. This shows that a single signal edge SE1 in the measurement period is sufficient for determining the propagation delay.

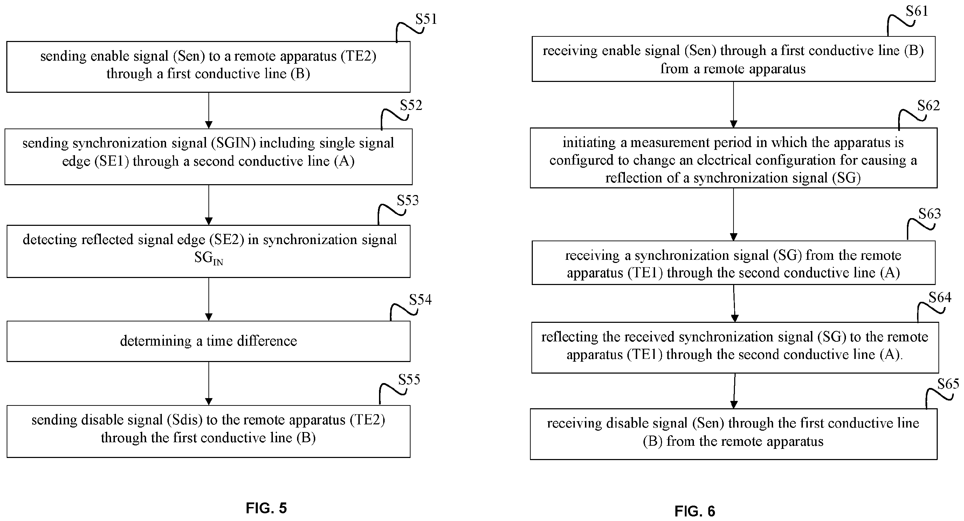

Other aspects are further described by reference to FIGS. 5 and 6 showing the steps S51 to S55 of a method performed by the first terminal element TE1 (FIG. 5) and the steps S61 to S65 of a method performed by the second terminal element TE2 respectively (FIG. 6).

At step S51, the first terminal element TE1 sends enable signal (Sen) to second terminal element TE2 to indicate the second terminal element TE2 the initiation of delay measurement. The enable signal (Sen) is a control signal transmitted through first conductive line B. According to some embodiments as shown in FIG. 2, where the PTP protocol is employed, it can be embedded in a data frame, which may allocate a dedicated bit for the signal Sen. It can be understood that the enable signal Sen can be carried in a so called PTP data frame. According to some embodiments as shown in FIG. 3, enable signal Sen can be sent in a ToD message. According to further embodiments, signal Sen may be included in a data frame sent from TE1 to TE2 through first conductive line B.

At step S61, the second terminal element TE2 receives the enable signal (Sen) from the first terminal element TE1.

At step S62, after reception (e.g. upon receipt) of the enable signal Sen, the second terminal element TE2 initiates a measurement period in which the second terminal element changes an electrical configuration to thereby cause a reflection at the second end A2 of the second conductive line A . This reflection occurs through the second conductive line A and is detectable at first end A1.

As shown in FIG. 4, the voltage level of SG_{OUT} at the second end A2 is forced to a logical level HL between times t1 and t2 (measurement period) and maintained to this logical level (as shown in bold line). The reflection may be activated for example by forcing the second end A2 to open circuit or to short circuit.

The second end A2 of the second conductive line A at the second terminal element TE2 may for example be forced to short circuit with its voltage level being maintained at a high logic level. Due to this change in electrical configuration and without requiring any additional operation like sending a signal, upon receipt of a signal edge, a reflected signal edge (e.g. negated signal edge) will be created at the second end A2 which propagates back to the first end A1 through the second conductive line A.

The enable signal Sen may be used to trigger the measurement mode in the temporal proximity to the falling edge of the synchronization signal SG. In some examples, TE1 sends the enable measurement signal Sen after a first signal edge of the synchronization signal and before the arrival of the next signal edge within a same synchronization period. In some examples, the next signal edge is used as the initial signal edge SE1, i.e. no signal edge needs to be inserted in the synchronization signal generated by (e.g. the master clock 20 of) the first terminal element TE.

At step S52, the first terminal element TE1 sends a synchronization signal SG to the second terminal element TE2 through the second conductive line A. The synchronization signal includes an initial signal edge SE1 during the measurement period, i.e. between times t1 and t2 as shown in FIG. 4.

In some examples, the signal edge SE1 is generated by applying a change of voltage at the first end A1 of the second conductive line A. In the example of FIG. 4, the signal edge SE1 is a falling edge. Alternatively a rising edge of SG_{IN} may employed. The present disclosure is not limited to the expression by such timing diagram.

At step S63, the synchronization signal SG_{OUT} including the signal edge SE1 is received at the second terminal element TE2.

At step S64, the received synchronization signal SG_{OUT} including the signal edge SE1 is reflected back to the remote apparatus, i.e. first terminal element TE1, through the second conductive line A, thereby causing a reflected signal edge SE2 to be inserted in the synchronization signal SG_{OUT}. This reflected signal edge SE2 is detectable in the synchronization signal SG_{IN} at the first end A1 after propagation through the second conductive line A.

At step S53, the first terminal element TE1 detects the reflected signal edge SE2 in the synchronization signal SC_{IN} at first end A1.

At step S54, by measuring the time difference between the initial signal edge SE1 and the reflected signal edge SE2 at first end A1 on the first terminal element TE1 (as shown on SG_{IN}), a resulting time is obtained which is twice the propagation delay δ of the cable. Thus, the propagation delay may be determined on the basis of half of the time difference.

According to some examples, the time difference ΔT between the initial signal edge SE1 and the reflected signal edge SE2 at first end A1 on TE1 equals the addition of a first delay ΔT1 and a second delay ΔT2, where ΔT1 is a difference between SE1 is sent from the first end A1 and SE1 is received at the second end A2, and ΔT2 is a difference between SE2 being induced at the second end A2 and SE2 becoming detected at the first end A1.

According to some examples, reflections can be induced by heavy maladjustment at the second end A2 as a form of negation, for example, by a short-cut or missing termination resistor.

The second conductive line A termination of rising or falling edge, when terminated correctly, may advantageously facilitate the edge detection and calculation of delay. This is already the case for the rising edge of SG which has a correct termination. During the falling edge used for delay measurement, the CPU 24 at first end A1 is configured to trigger heavy maladjustment at second end to induce reflections.

The advantage of using induced reflections is that the generation of the reflections at the second end A2 is immediate. This way, the present disclosure provides terminal elements that overcomes the delay asymmetry problem due to a non-bidirectional structure of wires, thus allowing calculating the cable delay by round-trip delay as in bidirectional system with perfect symmetry in the two directions.

At step S55, the first terminal element TE1 sends a disable signal (Sdis) to second terminal element TE2 through first conductive line B for causing the second terminal element TE2 to exit from the measurement mode. This may be performed after the detection of the reflected signal edge SE2 by the first terminal element TE1 or after determination of the propagation delay.

At step S65, the second terminal element receives the disable signal (Sdis) through the first conductive line B. After receipt (e.g. upon receipt) of the disable signal (Sdis), the second terminal element deactivates the electrical configuration (e.g. electrical connection) at the second end A2 of the second conductive line A to interrupt reflection at the second end (A2) of the second conductive line A.

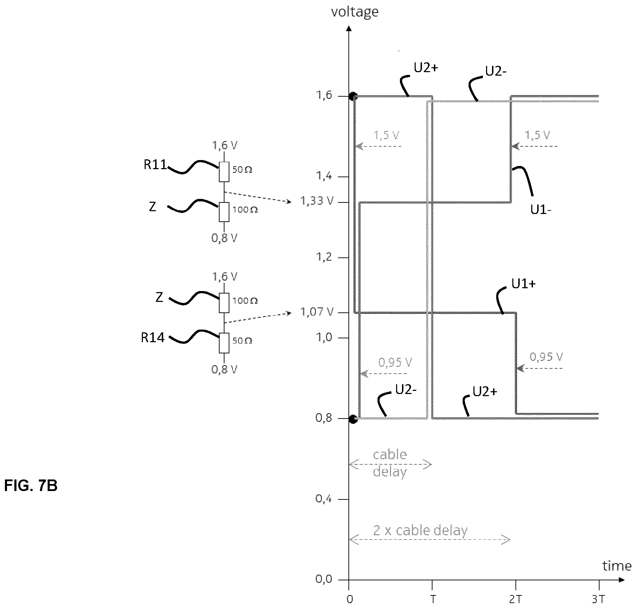

FIG. 7A shows an electronic circuit with Low Voltage Differential Signaling (LVDS) for realizing delay measurement according to the present disclosure. FIG. 7B shows the relationship between time and various voltage levels.

With reference to FIG. 7A, the conductive line A has an impedance Z and includes two twisted wires (differential pair of wires) connecting a LVDS source 70 and a LVDS sink 71. In some examples, the LVDS source 70 is connected to the first end A1 (transmitter end) of the conductive line A, and the LVDS sink 71 is connected to the second end A2 (receiving end) of the conductive line A. The LVDS source 70 is configured to generate the synchronization signal SG between voltage nodes U1+ and U1- at the first end A1 of the conductive line A. At the first end A1, a constant current of 3.5 mA is injected into the twisted wire, with the direction of the current determining the logic level. In some examples, two voltages U1+ and U1- at the first end A1 are applied to the first end A1 through the wires of the conductive line A having an impedance for example of 100 Ω. At the second end A2, the current passes through a termination resistor R7 of 100 Ω at the receiving end causing a voltage difference between the receiver inputs. A positive differential voltage between the voltage nodes U1+ and U1- represents high logic level, and a negative differential voltage represents low logic level.

In the lower part of FIG. 7A, two start delay receivers RX1 and RX2 and two stop delay receivers RX3 and RX4 of a measurement circuit 72 are shown.

For the first start delay receiver RX1, the two inputs correspond to U1- and a reference voltage of 0.95 V from a circuit 73 used as reference voltage source. For the second start delay receiver RX2, the two inputs correspond to U1+ and a reference voltage of 1.5V from the reference voltage source 73.

The voltage values of U1+ and U1- may vary as a function of the impedance values R11, R12, R13, R14 of the resistors in the LVDS source 70 circuit (upper part of FIG. 7A and the left part of FIG. 7B).

It is shown in the lower part of FIG. 7A that in a delay measurement circuit 72, at time t=0, output signals of a rising edge and a falling edge respectively from the first and the second start delay receivers RX1 and RX2 result in a start signal at the output of receiver RX12, meaning delay measurement starts; at time t=2T, output signals of a rising edge and a falling edge respectively from the first and the second stop delay receivers RX3 and RX4 result in a stop signal at the output of receiver RX34. Principle of the stop delay receiver can be understood with reference to the start delay receiver and will not be repeated here.

In some examples, the reflection at the second end A2 may be caused by switching the termination resistor R7 in the LVDS sink 71 from "force to logical 1" mode to "disable the termination resistor" mode. Although both modes may cause reflection, a disabled termination resistor is easier for use in the LVDS circuit, which will be explained below in more details.

FIG. 7B shows respective voltage levels of U1+, U1-, U2+, U2- when the termination resistor is disabled.

At time t=0, U1- rises from 0.8v to 1.33v (to above 0.95v), resulting in a rising edge at the output of the first start delay receiver; U1+ drops from 1.6v to 1.07v (to below 1.5V), resulting in a falling edge at the output of the second start delay receiver, the delay measurement starts and a "start signal" is generated at the output of receiver RX12.

At time t=2T, U1- rises from 1.33v to 1.6v (to above 1.5v), resulting in a rising edge at the output of the first stop delay receiver; U1+ drops from 1.07v to 0.8v (to below 0.95V), resulting in a falling edge at the output of the second stop delay receiver, the delay measurement stops and a "stop signal" is generated at the output of receiver RX34.

A start/stop counter may be used to extract the time difference from the "start signal" and the "stop signal". The start/stop counter is started at t=0 and stopped at t=2T. The higher the working frequency of counter, the higher the resolution/accuracy of the measurement of the time difference.

It should be appreciated by those skilled in the art that any block diagrams herein represent conceptual views of illustrative circuitry embodying the principles of the disclosure. Similarly, it will be appreciated that any flow charts, flow diagrams, state transition diagrams, and the like represent various processes which may be substantially implemented circuitry.

The first and second apparatus or terminal element TE1, TE2 may each include circuitry for performing the functions defined herein for the first terminal element TE1 or the second terminal element TE2 respectively.

It will be appreciated that steps of above-described methods may be performed by programmed computers or apparatuses. Herein, some embodiments are also intended to cover a computer readable medium, e.g., digital data storage media, which are machine or computer readable and encode machine- executable or computer-executable programs of instructions, wherein the instructions cause the apparatus TE1 or TE2 to perform some or all of the steps of said above-described methods.

A computer readable medium may be or include, e.g., digital memories, magnetic storage media such as a magnetic disks and magnetic tapes, hard drives, or optically readable digital data storage media, EPROM, EEPROM, flash memory devices, magneto-optical disks, CD-ROM and DVD-ROM disks, etc. The embodiments are also intended to cover computers programmed to perform some or all of the steps of the above-described methods.

The functions of the various elements shown in the figures, including any functional blocks labeled as "processors", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), or any other integrated circuit configured to perform one or more steps or processes described herein. Other hardware, conventional and/or custom, may also be included. Similarly, any routers shown in the figures are conceptual only. Their function may be carried out through the operation of program logic, through dedicated logic, through the interaction of program control and dedicated logic, or even manually, the particular technique being selectable by the implementer as more specifically understood from the context.

For example, the apparatus TE1 or TE2 also may include means to perform some or all of the steps of the above-described methods, wherein the means may include at least one processor and at least one memory including computer program code, the at least one memory and the computer program code being configured to, with the at least one processor, cause the apparatus TE1 or TE2 at least to perform some or all of the steps of the above-described methods.

For example, the apparatus TE1 or TE2 also may include, or be operatively coupled to receive data from and / or transfer data to a computer-readable storage medium suitable for embodying computer program instructions to cause the apparatus TE1 or TE2 to perform some or all of the steps of said above-described methods..

The processor of the apparatus TE1 or TE2 may be configured to access to one or more memories for storing instructions and data and to execute instructions. The processor may be configured to store, read, load and/or otherwise process computer program code stored in a computer-readable storage medium and / or in the memory that, when executed by the at least one processor, causes the apparatus to perform one or more steps of a method described herein for the concerned apparatus. Processors suitable for the execution of a computer program include, by way of example, both general and special purpose microprocessors, and any one or more processors of any kind of digital computer, chip or chipset. A processor may receive instructions and data from a read-only memory or a random access memory or both.

The processor may be any suitable processor, e.g. a microprocessor, microcontroller, integrated circuit, or central processing unit (CPU) including at least one hardware-based processor or processing core.

The memory of the apparatus TE1 or TE2 may include a random access memory (RAM), cache memory, non-volatile memory, backup memory (e.g., programmable or flash memories), read-only memory (ROM), a hard disk drive (HDD), a solid state drive (SSD) or any combination thereof. The ROM of the memory may be configured to store, amongst other things, an operating system of the apparatus TE1 or TE2 and / or one or more computer program codes of one or more computer programs. The RAM of the memory may be used by the processor for the temporary storage of data.

Functional blocks denoted as "means configured to perform ..." (a certain function) shall be understood as functional blocks comprising circuitry that is adapted for performing or configured to perform a certain function. A means being configured to perform a certain function does, hence, not imply that such means necessarily is performing said function (at a given time instant). Moreover, any entity described herein as "means", may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, other integrated circuits configured to perform one or more steps or processes described herein. Other hardware, conventional or custom, may also be included. Their function may be carried out through the operation of program logic, through dedicated logic, through the interaction of program control and dedicated logic, or even manually, the particular technique being selectable by the implementer as more specifically understood from the context.

As used in this application, the term "circuitry" may refer to one or more or all of the following:
(a) hardware-only circuit implementations (such as implementations in only analog and/or digital circuitry) and
(b) combinations of hardware circuits and software, such as (as applicable) : (i) a combination of analog and/or digital hardware circuit(s) with software/firmware and (ii) any portions of hardware processor(s) with software (including digital signal processor(s)), software, and memory(ies) that work together to cause an apparatus, such as a mobile phone or server, to perform various functions); and
(c) hardware circuit(s) and or processor(s), such as a microprocessor(s) or a portion of a microprocessor(s), that requires software (e.g., firmware) for operation, but the software may not be present when it is not needed for operation."

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, an integrated circuit for a network element or network node or any other computing device or network device. The term circuitry may cover digital signal processor (DSP) hardware, network processor, application specific integrated circuit (ASIC), field programmable gate array (FPGA), etc.

The circuitry may be or include, for example, hardware, programmable logic, a programmable processor that executes software or firmware, and/or any combination thereof (e.g. a processor, control unit/entity, controller) to execute instructions or software and control transmission and receptions of signals, and a memory to store data and/or instructions.

The circuitry may also make decisions or determinations, generate frames, packets or messages for transmission, decode received frames or messages for further processing, and other tasks or functions described herein. The circuitry may control transmission of signals or messages over a radio network, and may control the reception of signals or messages, etc., via a radio network (e.g., after being down-converted by radio transceiver, for example).

While aspects of the present disclosure have been particularly shown and described with reference to the embodiments above, it will be understood by those skilled in the art that various additional embodiments may be contemplated by the modification of the disclosed machines, systems and methods without departing from the scope of what is disclosed. Such embodiments should be understood to fall within the scope of the present disclosure as determined based upon the claims.

## Claims

1. An apparatus (TE1) for measuring propagation delay in a cable, the apparatus being configured to:
- send through a first conductive line (B) of the cable an enable signal (Sen) to a remote apparatus (TE2), the enable signal (Sen) being indicative of a start of a measurement period;
- send, during the measurement period, a synchronization signal (SG) to the remote apparatus (TE2) through a second conductive line (A) of the cable, the synchronization signal (SG) including an initial signal edge (SE1);
- detect a reflected signal edge (SE2) in the synchronization signal (SG), wherein the reflected signal edge (SE2) is generated by reflection of the initial signal edge (SE1) at the remote apparatus (TE2);
- determine a propagation delay for the cable, wherein said propagation delay is half of a time difference between the sending of the initial signal edge (SE1) by the apparatus (TE1) and the reception of the reflected signal edge (SE2) by the apparatus (TE1).

2. The apparatus according to claim 1, wherein the initial signal edge (SE1) is a falling edge and the reflected signal edge (SE2) is a rising edge or vice versa.

3. The apparatus according to claim 1 or 2, wherein the apparatus is configured to apply to a first end (A1) of the second conductive line (A) a change of voltage to generate the initial signal edge (SE1) and to detect a negated change of voltage corresponding to the reflected signal edge (SE2).

4. The apparatus according to any of claims 1 to 3, wherein the synchronization signal comprises a periodic variation between a low logic level and a high logic level, the periodic variation defining signal edges, wherein the apparatus is configured to send the enable signal (Sen) after a first signal edge of the synchronization signal and before the next signal edge within a same synchronization period, wherein the next signal edge is the initial signal edge (SE1).

5. The apparatus according to any of claims 1 to 4, wherein the apparatus is configured to send a disable signal (Sdis) to the remote apparatus (TE2) through the first conductive line (B) after the detection of the reflected signal edge (SE2), the disable signal (Sdis) being indicative of an end of the measurement period.

6. The apparatus according to claim 1 to 5, wherein the apparatus (TE1) is configured to send through the first conductive line (B) data frames according to a protocol, wherein the apparatus (TE1) is configured to include the enable signal (Sen) in a data frame according to said protocol.

7. An apparatus (TE2) configured to:
- receive, through a first conductive line (B) of a cable, an enable signal (Sen) from a remote apparatus (TE1);
- after receipt of the enable signal (Sen), initiating a measurement period in which the apparatus is configured to change an electrical configuration for causing a reflection of a synchronization signal (SG) received by the apparatus at an end of a second conductive line (A) connected to the apparatus;
- receive a synchronization signal (SG) from the remote apparatus (TE1) at said end of the second conductive line (A);
- reflect said received synchronization signal (SG) to the remote apparatus (TE1) using said second conductive line (A).

8. The apparatus (TE2) according to claim 7, wherein said change in the electrical configuration includes changing the electrical connection of the end of the second conductive line (A).

9. The apparatus (TE2) according to claim 8, wherein changing the electrical connection of the end of the second conductive line (A) includes forcing a short circuit or an open circuit to cause the reflection at the end (A2) of the second conductive line (A).

10. The apparatus (TE2) according to any of claims 7 to 9, wherein the apparatus (TE2) is configured to receive through the first conductive line (B) a disable signal (Sdis) from the remote apparatus (TE1) and to interrupt the reflection at the end of a second conductive line (A) after receipt of the disable signal (Sdis).

11. The apparatus (TE2) according to any of claims 7 to 9, wherein the apparatus (TE2) is configured to start a timeout period after receipt of the enable signal (Sen) and to interrupt the reflection at the end of a second conductive line (A) after the timeout period has lapsed.

12. A network element comprising a first apparatus (TE1) according to any of claims 1 to 6 and / or a second apparatus (TE2) according to any of claims 7 to 11.

13. A method for propagation delay determination, the method comprising:
- sending (S51), from a first apparatus, through a first conductive line (B) of a cable an enable signal (Sen) to a second apparatus (TE2) to indicate a start of a measurement period;
- sending (S52), during the measurement period, a synchronization signal (SG) from the first apparatus to the second apparatus (TE2) through a second conductive line (A) of the cable, the synchronization signal (SG) including an initial signal edge (SE1);
- detecting (S53), by the first apparatus, a reflected signal edge (SE2) in the synchronization signal (SG), wherein the reflected signal edge (SE2) is generated by reflection of the initial signal edge (SE1) at the second apparatus (TE2);
- determining (S54) a propagation delay for the cable, wherein said propagation delay is half of a time difference between the sending of the initial signal edge (SE1) by the apparatus (TE1) and the reception of the reflected signal edge (SE2) by the apparatus (TE1).

14. A method for configuring an apparatus for measuring propagation delay, the method comprising:
- receiving (S61), through a first conductive line (B) of a cable, an enable signal (Sen) from a remote apparatus (TE1);
- after receipt of the enable signal (Sen), initiating (S62) a measurement period in which the apparatus is configured to change an electrical configuration for causing a reflection of a synchronization signal (SG) received by the apparatus at an end of a second conductive line (A) connected to the apparatus;
- receiving (S63) a synchronization signal (SG) from the remote apparatus (TE1) at said end of the second conductive line (A);
- reflecting (S64) said received synchronization signal (SG) to the remote apparatus (TE1) using said second conductive line (A).

15. An apparatus comprising:
- at least one processor;
- at least one memory including computer program code;
the at least one memory and the computer program code being configured to, with the at least one processor, cause the apparatus at least to perform:
- sending, through a first conductive line (B) of a cable an enable signal (Sen) to a remote apparatus (TE2) to indicate a start of a measurement period;
- sending, during the measurement period, a synchronization signal (SG) to the remote apparatus (TE2) through a second conductive line (A) of the cable, the synchronization signal (SG) including an initial signal edge (SE1);
- detecting, a reflected signal edge (SE2) in the synchronization signal (SG), wherein the reflected signal edge (SE2) is generated by reflection of the initial signal edge (SE1) at the remote apparatus (TE2);
- determining a propagation delay for the cable, wherein said propagation delay is half of a time difference between the sending of the initial signal edge (SE1) by the apparatus (TE1) and the reception of the reflected signal edge (SE2) by the apparatus (TE1).

## Patentansprüche

1. Vorrichtung (TE1) zum Messen der Ausbreitungsverzögerung in einem Kabel, wobei die Vorrichtung konfiguriert ist zum:
- Senden eines Aktivierungssignals (Sen) über eine erste leitende Leitung (B) des Kabels an eine entfernte Vorrichtung (TE2), wobei das Aktivierungssignal (Sen) den Beginn eines Messzeitraums anzeigt;
- Senden, während des Messzeitraums, eines Synchronisationssignals (SG) an die entfernte Vorrichtung (TE2) über eine zweite leitende Leitung (A) des Kabels, wobei das Synchronisationssignal (SG) eine ursprüngliche Signalflanke (SE1) beinhaltet;
- Erkennen einer reflektierten Signalflanke (SE2) in dem Synchronisationssignal (SG), wobei die reflektierte Signalflanke (SE2) durch Reflexion der ursprünglichen Signalflanke (SE1) an der entfernten Vorrichtung (TE2) erzeugt wird;
- Bestimmen einer Ausbreitungsverzögerung für das Kabel, wobei die Ausbreitungsverzögerung die Hälfte einer Zeitdifferenz zwischen dem Senden der ursprünglichen Signalflanke (SE1) durch die Vorrichtung (TE1) und dem Empfangen der reflektierten Signalflanke (SE2) durch die Vorrichtung (TE1) ist.

2. Vorrichtung nach Anspruch 1, wobei die ursprüngliche Signalflanke (SE1) eine abfallende Flanke ist und die reflektierte Signalflanke (SE2) eine ansteigende Flanke ist oder umgekehrt.

3. Vorrichtung nach Anspruch 1 oder 2, wobei die Vorrichtung dafür konfiguriert ist, an ein erstes Ende (Al) der zweiten leitenden Leitung (A) eine Spannungsänderung anzulegen, um die ursprüngliche Signalflanke (SE1) zu erzeugen, und eine negierte Spannungsänderung zu erkennen, die der reflektierten Signalflanke (SE2) entspricht.

4. Vorrichtung nach einem der Ansprüche 1 bis 3, wobei das Synchronisationssignal eine periodische Variation zwischen einem niedrigen logischen Pegel und einem hohen logischen Pegel umfasst, wobei die periodische Variation Signalflanken definiert, wobei die Vorrichtung dafür konfiguriert ist, das Aktivierungssignal (Sen) nach einer ersten Signalflanke des Synchronisationssignals und vor der nächsten Signalflanke innerhalb derselben Synchronisationsperiode zu senden, wobei die nächste Signalflanke die ursprüngliche Signalflanke (SE1) ist.

5. Vorrichtung nach einem der Ansprüche 1 bis 4, wobei die Vorrichtung dafür konfiguriert ist, nach dem Erkennen der reflektierten Signalflanke (SE2) ein Deaktivierungssignal (Sdis) über die erste leitende Leitung (B) an die entfernte Vorrichtung (TE2) zu senden, wobei das Deaktivierungssignal (Sdis) ein Ende des Messzeitraums anzeigt.

6. Vorrichtung nach Anspruch 1 bis 5, wobei die Vorrichtung (TE1) dafür konfiguriert ist, über die erste leitende Leitung (B) Datenframes gemäß einem Protokoll zu senden, wobei die Vorrichtung (TE1) dafür konfiguriert ist, das Aktivierungssignal (Sen) in einen Datenframe gemäß dem Protokoll zu integrieren.

7. Vorrichtung (TE2), die konfiguriert ist zum:
- Empfangen eines Aktivierungssignals (Sen) von einer entfernten Vorrichtung (TE1) über eine erste leitende Leitung (B) eines Kabels;
- nach dem Empfang des Aktivierungssignals (Sen) Initiieren eines Messzeitraums, in dem die Vorrichtung dafür konfiguriert ist, eine elektrische Konfiguration zu ändern, um eine Reflexion eines Synchronisationssignals (SG) zu bewirken, das von der Vorrichtung an einem Ende einer zweiten leitenden Leitung (A), die mit der Vorrichtung verbunden ist, empfangen wird;
- Empfangen eines Synchronisationssignals (SG) von der entfernten Vorrichtung (TE1) an dem Ende der zweiten leitenden Leitung (A);
- Reflektieren des empfangenen Synchronisationssignals (SG) an die entfernte Vorrichtung (TE1) unter Verwendung der zweiten leitenden Leitung (A).

8. Vorrichtung (TE2) nach Anspruch 7, wobei die Änderung der elektrischen Konfiguration das Ändern des elektrischen Anschlusses des Endes der zweiten leitenden Leitung (A) beinhaltet.

9. Vorrichtung (TE2) nach Anspruch 8, wobei das Ändern des elektrischen Anschlusses des Endes der zweiten leitenden Leitung (A) das Erzwingen eines Kurzschlusses oder eines offenen Stromkreises beinhaltet, um die Reflexion an dem Ende (A2) der zweiten leitenden Leitung (A) zu bewirken.

10. Vorrichtung (TE2) nach einem der Ansprüche 7 bis 9, wobei die Vorrichtung (TE2) dafür konfiguriert ist, über die erste leitende Leitung (B) ein Deaktivierungssignal (Sdis) von der entfernten Vorrichtung (TE1) zu empfangen und nach dem Empfang des Deaktivierungssignals (Sdis) die Reflexion an dem Ende einer zweiten leitenden Leitung (A) zu unterbrechen.

11. Vorrichtung (TE2) nach einem der Ansprüche 7 bis 9, wobei die Vorrichtung (TE2) dafür konfiguriert ist, nach dem Empfang des Aktivierungssignals (Sen) eine Timeout-Periode zu beginnen und nach Ablauf der Timeout-Periode die Reflexion an dem Ende einer zweiten leitenden Leitung (A) zu unterbrechen.

12. Netzwerkelement umfassend eine erste Vorrichtung (TE1) nach einem der Ansprüche 1 bis 6 und/oder eine zweite Vorrichtung (TE2) nach einem der Ansprüche 7 bis 11.

13. Verfahren zur Bestimmung der Ausbreitungsverzögerung, wobei das Verfahren umfasst:
- Senden (S51) eines Aktivierungssignals (Sen) von einer ersten Vorrichtung über eine erste leitende Leitung (B) eines Kabels an eine zweite Vorrichtung (TE2), um den Beginn eines Messzeitraums anzuzeigen;
- Senden (S52), während des Messzeitraums, eines Synchronisationssignals (SG) von der ersten Vorrichtung an die zweite Vorrichtung (TE2) über eine zweite leitende Leitung (A) des Kabels, wobei das Synchronisationssignal (SG) eine ursprüngliche Signalflanke (SE1) beinhaltet;
- Erkennen (S53), durch eine erste Vorrichtung, einer reflektierten Signalflanke (SE2) in dem Synchronisationssignal (SG), wobei die reflektierte Signalflanke (SE2) durch Reflexion der ursprünglichen Signalflanke (SE1) an der zweiten Vorrichtung (TE2) erzeugt wird;
- Bestimmen (S54) einer Ausbreitungsverzögerung für das Kabel, wobei die Ausbreitungsverzögerung die Hälfte einer Zeitdifferenz zwischen dem Senden der ursprünglichen Signalflanke (SE1) durch die Vorrichtung (TE1) und dem Empfangen der reflektierten Signalflanke (SE2) durch die Vorrichtung (TE1) ist.

14. Verfahren zum Konfigurieren einer Vorrichtung für die Messung der Ausbreitungsverzögerung, wobei das Verfahren umfasst:
- Empfangen (S61) eines Aktivierungssignals (Sen) von einer entfernten Vorrichtung (TE1) über eine erste leitende Leitung (B) eines Kabels;
- nach dem Empfang des Aktivierungssignals (Sen) Initiieren (S62) eines Messzeitraums, in dem die Vorrichtung dafür konfiguriert ist, eine elektrische Konfiguration zu ändern, um eine Reflexion eines Synchronisationssignals (SG) zu bewirken, das von der Vorrichtung an einem Ende einer zweiten leitenden Leitung (A), die mit der Vorrichtung verbunden ist, empfangen wird;
- Empfangen (S63) eines Synchronisationssignals (SG) von der entfernten Vorrichtung (TE1) an dem Ende der zweiten leitenden Leitung (A);
- Reflektieren (S64) des empfangenen Synchronisationssignals (SG) an die entfernte Vorrichtung (TE1) unter Verwendung der zweiten leitenden Leitung (A).

15. Vorrichtung umfassend:
- zumindest einen Prozessor;
- zumindest einen Speicher, der Computerprogrammcode beinhaltet;
wobei der zumindest eine Speicher und der Computerprogrammcode dafür konfiguriert sind, zusammen mit dem zumindest einen Prozessor die Vorrichtung zumindest zu veranlassen zum:
- Senden eines Aktivierungssignals über eine erste leitende Leitung (B) eines Kabels an eine entfernte Vorrichtung (TE2), um den Beginn eines Messzeitraums anzuzeigen;
- Senden, während des Messzeitraums, eines Synchronisationssignals (SG) an die entfernte Vorrichtung (TE2) über eine zweite leitende Leitung (A) des Kabels, wobei das Synchronisationssignal (SG) eine ursprüngliche Signalflanke (SE1) beinhaltet;
- Erkennen einer reflektierten Signalflanke (SE2) in dem Synchronisationssignal (SG), wobei die reflektierte Signalflanke (SE2) durch Reflexion der ursprünglichen Signalflanke (SE1) an der entfernten Vorrichtung (TE2) erzeugt wird;
- Bestimmen einer Ausbreitungsverzögerung für das Kabel, wobei die Ausbreitungsverzögerung die Hälfte einer Zeitdifferenz zwischen dem Senden der ursprünglichen Signalflanke (SE1) durch die Vorrichtung (TE1) und dem Empfangen der reflektierten Signalflanke (SE2) durch die Vorrichtung (TE1) ist.

## Revendications

1. Appareil (TE1) pour mesurer un temps de propagation dans un câble, l'appareil étant configuré pour :
- envoyer, à travers une première ligne conductrice (B) du câble, un signal d'activation (Sen) à un appareil (TE2) distant, le signal d'activation (Sen) indiquant le début d'une période de mesure ;
- envoyer, pendant la période de mesure, un signal de synchronisation (SG) à l'appareil (TE2) distant à travers une deuxième ligne conductrice (A) du câble, le signal de synchronisation (SG) comportant un front de signal initial (SE1) ;
- détecter un front de signal réfléchi (SE2) dans le signal de synchronisation (SG), dans lequel le front de signal réfléchi (SE2) est généré par la réflexion du front de signal initial (SE1) au niveau de l'appareil (TE2) distant ;
- déterminer un temps de propagation pour le câble, dans lequel ledit temps de propagation fait la moitié d'une différence temporelle entre l'envoi du front de signal initial (SE1) par l'appareil (TE1) et la réception du front de signal réfléchi (SE2) par l'appareil (TE1).

2. Appareil selon la revendication 1, dans lequel le front de signal initial (SE1) est un front descendant et le front de signal réfléchi (SE2) est un front montant ou vice versa.

3. Appareil selon la revendication 1 ou 2, dans lequel l'appareil est configuré pour appliquer à une première extrémité (A1) de la deuxième ligne conductrice (A) un changement de tension pour générer le front de signal initial (SE1) et pour détecter un changement de tension inversé correspondant au front de signal réfléchi (SE2).

4. Appareil selon l'une des revendications 1 à 3, dans lequel le signal de synchronisation comprend une variation périodique entre un niveau logique bas et un niveau logique haut, la variation périodique définissant des fronts de signal, dans lequel l'appareil est configuré pour envoyer le signal d'activation (Sen) après un premier front de signal du signal de synchronisation et avant le front de signal suivant au cours d'une même période de synchronisation, dans lequel le front de signal suivant est le front de signal initial (SE1).

5. Appareil selon l'une des revendications 1 à 4, dans lequel l'appareil est configuré pour envoyer un signal de désactivation (Sdis) à l'appareil (TE2) distant à travers la première ligne conductrice (B) après la détection du front de signal réfléchi (SE2), le signal de désactivation (Sdis) indiquant la fin de la période de mesure.

6. Appareil selon la revendication 1 à 5, dans lequel l'appareil (TE1) est configuré pour envoyer, à travers la première ligne conductrice (B), des trames de données selon un protocole, dans lequel l'appareil (TE1) est configuré pour inclure le signal d'activation (Sen) dans une trame de données selon ledit protocole.

7. Appareil (TE2) configuré pour :
- recevoir, à travers une première ligne conductrice (B) d'un câble, un signal d'activation (Sen) en provenance d'un appareil (TE1) distant ;
- après réception du signal d'activation (Sen), initier une période de mesure au cours de laquelle l'appareil est configuré pour changer une configuration électrique afin de provoquer une réflexion d'un signal de synchronisation (SG) reçu par l'appareil à une extrémité d'une deuxième ligne conductrice (A) connectée à l'appareil ;
- recevoir un signal de synchronisation (SG) en provenance de l'appareil (TE1) distant à ladite extrémité de la deuxième ligne conductrice (A) ;
- réfléchir ledit signal de synchronisation (SG) reçu vers l'appareil (TE1) distant en utilisant ladite deuxième ligne conductrice (A).

8. Appareil (TE2) selon la revendication 7, dans lequel ledit changement de la configuration électrique comporte le changement de la connexion électrique de l'extrémité de la deuxième ligne conductrice (A).

9. Appareil (TE2) selon la revendication 8, dans lequel le changement de la connexion électrique de l'extrémité de la deuxième ligne conductrice (A) comporte le fait de forcer un court-circuit ou un circuit ouvert pour provoquer la réflexion à l'extrémité (A2) de la deuxième ligne conductrice (A).

10. Appareil (TE2) selon l'une des revendications 7 à 9, dans lequel l'appareil (TE2) est configuré pour recevoir, à travers la première ligne conductrice (B), un signal de désactivation (Sdis) en provenance de l'appareil (TE1) distant, et pour interrompre la réflexion à l'extrémité d'une deuxième ligne conductrice (A) après réception du signal de désactivation (Sdis).

11. Appareil (TE2) selon l'une des revendications 7 à 9, dans lequel l'appareil (TE2) est configuré pour démarrer une période de temporisation après réception du signal d'activation (Sen) et pour interrompre la réflexion à l'extrémité d'une deuxième ligne conductrice (A) une fois la période de temporisation écoulée.

12. Élément de réseau comprenant un premier appareil (TE1) selon l'une des revendications 1 à 6 et/ou un deuxième appareil (TE2) selon l'une des revendications 7 à 11.

13. Procédé de détermination d'un temps de propagation, le procédé comprenant :
- l'envoi (S51), d'un premier appareil, à travers une première ligne conductrice (B) d'un câble, d'un signal d'activation (Sen) à un deuxième appareil (TE2) pour indiquer le début d'une période de mesure ;
- l'envoi (S52), pendant la période de mesure, d'un signal de synchronisation (SG) du premier appareil au deuxième appareil (TE2) à travers une deuxième ligne conductrice (A) du câble, le signal de synchronisation (SG) comportant un front de signal initial (SE1) ;
- la détection (S53), par le premier appareil, d'un front de signal réfléchi (SE2) dans le signal de synchronisation (SG), dans lequel le front de signal réfléchi (SE2) est généré par la réflexion du front de signal initial (SE1) au niveau du deuxième appareil (TE2) ;
- la détermination (S54) d'un temps de propagation pour le câble, dans lequel ledit temps de propagation fait la moitié d'une différence temporelle entre l'envoi du front de signal initial (SE1) par l'appareil (TE1) et la réception du front de signal réfléchi (SE2) par l'appareil (TE1).

14. Procédé de configuration d'un appareil pour mesurer un temps de propagation, le procédé comprenant :
- la réception (S61), à travers une première ligne conductrice (B) d'un câble, d'un signal d'activation (Sen) en provenance d'un appareil (TE1) distant ;
- après réception du signal d'activation (Sen), l'initiation (S62) d'une période de mesure au cours de laquelle l'appareil est configuré pour changer une configuration électrique afin de provoquer une réflexion d'un signal de synchronisation (SG) reçu par l'appareil à une extrémité d'une deuxième ligne conductrice (A) connectée à l'appareil ;
- la réception (S63) d'un signal de synchronisation (SG) en provenance de l'appareil (TE1) distant à ladite extrémité de la deuxième ligne conductrice (A) ;
- la réflexion (S64) dudit signal de synchronisation (SG) reçu vers l'appareil (TE1) distant en utilisant ladite deuxième ligne conductrice (A).

15. Appareil comprenant :
- au moins un processeur ;
- au moins une mémoire comportant un code de programme informatique ;
l'au moins une mémoire et le code de programme informatique étant configurés pour, avec l'au moins un processeur, amener l'appareil à réaliser au moins :
- l'envoi, à travers une première ligne conductrice (B) d'un câble, d'un signal d'activation (Sen) à un appareil (TE2) distant pour indiquer le début d'une période de mesure ;
- l'envoi, pendant la période de mesure, d'un signal de synchronisation (SG) à l'appareil (TE2) distant à travers une deuxième ligne conductrice (A) du câble, le signal de synchronisation (SG) comportant un front de signal initial (SE1) ;
- la détection d'un front de signal réfléchi (SE2) dans le signal de synchronisation (SG), dans lequel le front de signal réfléchi (SE2) est généré par la réflexion du front de signal initial (SE1) au niveau de l'appareil (TE2) distant ;
- la détermination d'un temps de propagation pour le câble, dans lequel ledit temps de propagation fait la moitié d'une différence temporelle entre l'envoi du front de signal initial (SE1) par l'appareil (TE1) et la réception du front de signal réfléchi (SE2) par l'appareil (TE1).
